# EUROPÄISCHE PATENTANMELDUNG

(11) **EP 2 262 018 A2**
(43) Veröffentlichungstag der Anmeldung: **15.12.2010**
(21) Anmeldenummer: 10164652.9
(22) Anmeldetag: 01.06.2010
(51) Int. Cl.: H01L 35/32

(54) **Thermoelektrische Vorrichtung und Verfahren zum Herstellen einer thermoelektrischen Vorrichtung**

(30) Priorität: 10.06.2009 DE 102009025033
(71) Anmelder: Behr GmbH & Co. KG, 70469 Stuttgart (DE)
(72) Erfinder: Brehm, Holger, 71729, Erdmannhausen (DE); Heckenberger, Thomas, 70771, Leinfelden-Echterdingen (DE); Himmer, Thomas, 73326, Reichenbach (Deggingen) (DE); Riedel, Rudolf, 75173, Pforzheim (DE)

(57) **Zusammenfassung**

Die vorliegende Erfindung betrifft eine thermoelektrische Vorrichtung (1) mit einem ersten Hüllkörperteil (2a) und einem gegenüberliegenden zweiten Hüllkörperteil (2b), die jeweils einen Randbereich (7) aufwehen und in dem Randbereich fluiddicht miteinander verbunden sind, um einen, zwischen dem ersten Hüllkörperteil und dem zweiten Hüllkörperteil angeordneten, nach außen fluiddicht abgeschlossenen Innenraum auszubilden, Die Vorrichtung (1) umfasst ferner eine Mehrzahl thermoelektrischer Elemente (3), die jeweils zwei gegenüberliegende Kontaktflächen aufweisen. Die thermoelektrischen Elemente (3) sind so in dem Innenraum angeordnet, das jeweils eine erste der Kontaktflächen dem ersten Hüllkörperteil gegenüberliegeng und eine zweite der Kontaktflächen dem zweiten Hüllkörperteil gegenüberliegend angeordnet ist. Das erste Hüllkkörperteil (2a) und das zweite Hüllkörperteil (2b) sind jeweils als Keramikgrundkörper ausgebildet, der zumindest in dem Randbereich (7) eine Metallisierung aufweist.

## Beschreibung

Die vorliegende Erfindung bezieht sich auf eine thermoelektrische Vorrichtung, einen Wärmetauscher und auf ein Verfahren zum Herstellen einer thermoelektrischen Vorrichtung.

Die im Abgas von Anlagen, beispielsweise von Fahrzeugen, in Form von Wärme gespeicherte Energie wird ungenutzt an die Umgebung abgeführt. Um den Wirkungsgrad der Anlage zu erhöhen, und folglich den CO2-Ausstoss im Betrieb zu senken, kann die Wärme des Abgases genutzt werden.

Entsprechende Ansätze finden sich in den Schriften EP1230475 B1, EP1475532 A2, WO2007026432, JP10281015 A, JP2000282960 A, JP2004068608A, JP2005083251A, JP2005117836A, 102009016363.8, CH74178A, DE102006009082A1, DE102006019282A1. DE102006022666B4, DE102006040853B3, DE102006040854A1, DE102006040855B3, DE102006043907A1. DE102007011954A1, DE102005009480A1, US4650919A, WO2002018852A1, WO2003094249A1, DE10107419A1, DE102005005077B4, JP411225491A, JP2000035825A1, JP2002325470A1, JP2005051934A1, JP2005083251A, JP2005117836A, JP2005127162A, US20050121173A1, US20050194034A1, WO2007048392A1; DE102007014433A1. DE102008001218A1, DE102008001220A1, DE102008001221A1, DE102008001226A1, DE102008001228A1, WO2007107601A2 und WO2008128947A1.

Um die Wärme des Abgases zu nutzen kann ein thermoelektrischer Generator (TEG) implementiert werden, dessen thermoelektrisches Modul (TEM) einen Teil der Wärme in elektrische Energie umwandelt und diese an die Anlage zurückführt. Der thermoelektrische Generator kann mit unterschiedlichem Nutzen an beliebiger Stelle im Abgasstrang oder in der Abgasrückführung untergebracht sein. Herkömmliche thermoelektrische Module sind auf Grund ihrer Gestaltung und Verbindungstechnik nicht optimal für den Einsatz in einem thermoelektrischen Generator geeignet und auch weniger effektiv.

Es ist die Aufgabe der vorliegenden Erfindung eine verbesserte thermoelektrische Vorrichtung, einen verbesserten Wärmetauscher sowie ein verbessertes Verfahren zum Herstellen einer thermoelektrischen Vorrichtung zu schaffen.

Diese Aufgabe wird durch eine thermoelektrische Vorrichtung gemäß Anspruch 1, einen Wärmetauscher gemäß Anspruch 9 sowie ein Verfahren zum Herstellen einer thermoelektrischen Vorrichtung gemäß Anspruch 13 gelöst.

Der vorliegenden Erfindung liegt die Erkenntnis zugrunde, dass eine Art der Anbindung zwischen thermoelektrischen Materialien und einem Hüllkörper, sowie eine Ausgestaltung des Hüllkörpers einen wesentlichen Einfluss auf die Effektivität und Eignung eines thermoelektrischen Moduls für den Einsatz in einem thermoelektrischen Generator haben. Der erfindungsgemäße Ansatz basiert dabei auf einem thermoelektrischen Modul, das mit thermoelektrisch aktivem Material bestückt ist. Wird dieses Material einer Temperaturdifferenz ausgesetzt, erzeugt das thermoelektrische Modul elektrische Energie. Die Temperaturdifferenz entsteht dadurch, dass die beiden gegenüberliegenden Hauptflächen einerseits mit einer Wärmequelle, z.B. Abgas und andererseits mit einer Wärmesenke, z.B. Kühlmittel in Kontakt stehen.

Erfindungsgemäß ist der Hüllkörper als ein Keramikgrundkörper ausgebildet, der metallisiert ist, so dass eine einfache stoffschlüssige Verbindung realisiert werden kann.

Die vorliegende Erfindung basiert auf einer Optimierung eines thermoelektrischen Moduls zur Erzeugung elektrischer Energie aus Wärmeenergie. Das erfindungsgemäße thermoelektrische Modul ist sehr effizient, auf Grund eines verringerten Wärmedurchgangswiderstandes zwischen thermoelektrisch aktiven Materialien und der Wärmequelle bzw. der Wärmesenke. Zudem ist eine Einbindung des thermoelektrischen Moduls in einen Wärmetauscher sehr praktikabel und eingesetzte Verbindungstechniken können hochtemperaturstabil ausgeführt sein.

Die vorliegende Erfindung schafft eine thermoelektrische Vorrichtung, mit folgenden Merkmalen: einem Hüllkörper mit einem ersten Hüllkörperteil und einem gegenüberliegenden zweiten Hüllkörperteil, die jeweils einen Randbereich aufweisen und in dem Randbereich fluiddicht miteinander verbunden sind, um einen, zwischen dem ersten Hüllkörperteil und dem zweiten Hüllkörperieil angeordneten, nach außen fluiddicht abgeschlossenen Innenraum auszubilden; und einer Mehrzahl thermoelektrischer Elemente, die jeweils zwei gegenüberliegende Kontaktflächen aufweisen, wobei die thermoelektrischen Elemente so in dem Innenraum angeordnet sind, das jeweils eine erste der Kontaktflächen dem ersten Hüllkörperteil gegenüberliegend und eine zweite der Kontaktflächen dem zweiten Hüllkörperteil gegenüberliegend angeordnet ist; dadurch gekennzeichnet, dass das erste Hüllkörperteil und das zweite Hüllkörperteil jeweils als Keramikgrundkörper ausgebildet sind, der zumindest in dem Randbereich eine Metallisierung aufweist.

Die thermoelektrische Vorrichtung kann zwischen einer Wärmequelle, beispielsweise einem Abgasstrom oder einer Abgasleitung einer Anlage, beispielsweise eines Fahrzeugs, und einer Wärmesenke, beispielsweise einem Kühlmittelstrom oder einer Kühlmittelleitung angeordnet sein. Dabei können das erste Hüllkörperteil wärmeleitend mit der Wärmequelle und das zweite Hüllkörperteil wärmeleitend mit der Wärmesenke, oder umgekehrt verbunden sein. Jedes thermoelektrische Element kann aus einem thermoelektrisch aktiven Material, zum Beispiel einem Halbleiter-Material, bestehen. Die thermoelektrischen Elemente können säulenförmig zwischen dem ersten Hüllkörperteil und dem zweiten Hüllkörperteil angeordnet sein und voneinander beabstandet sein. Dabei können die thermoelektrischen Elemente beispielsweise in einer Mehrzahl von Reihen und Spalten angeordnet sein. Dir Kontaktflächen können parallel zu der ersten und der zweiten Fläche angeordnet sein. Je nach Ausrichtung können die Kontaktflächen entweder mit dem ersten Hüllkörperteil oder mit dem zweiten Hüllkörperkeil wärmeleitend verbunden sein. Über die Kontaktflächen können die thermoelektrischen Elemente elektrisch kontaktiert werden. Die elektrische Verbindung der thermoelektrischen Elemente kann in Form einer Serienschaltung oder einer Parallelschaltung erfolgen. Zudem können mehrere einzelne Serienschaltungen wiederum parallel geschaltet werden. Die Hüllkörperteile können rechteckige Platten darstellen, die an den Rändern gebogene Abschnitte oder Erhöhungen aufweisen können, über die die Hüllkörperteile verbunden werden können. Die Metallisierung der Hüllkörperteile ermöglicht beispielsweise ein Verlöten der beiden Hüllkörperteile.

Dabei kann zumindest einer der Randbereiche Fügestellen aufweisen, die ineinandergreifen, wenn das erste und das zweite Hüllkörperteil miteinander verbunden sind. Die Fügestellen können umlaufend, um das jeweilige Hüllkörperteil ausgebildet sein und eine stabile Verbindung zwischen den beiden Hüllkörperteilen ermöglichen.

Der Hüllkörper kann an zumindest einem Randbereich eine Abschrägung aufweisen, die zwischen dem ersten und dem zweiten Hüllkörperteil verläuft. Auf diese Weise kann eine strömungsbezogene Eintrittsstelle bzw. Austrittsstelle für ein wärmezuführendes oder wärmeabführendes Fluid geschaffen werden, wenn die thermoelektrische Vorrichtung in einem Wärmetauscher angeordnet ist.

Ferner kann zumindest eines der ersten und zweiten Hüllkörperteile auf einer, dem Innenraum gegenüberliegenden Seite, eine Erhöhung aufweisen, die entlang zumindest eines Randes des entsprechenden Hüllkörperteils verläuft. Insbesondere kann die Erhöhung an Rändern ausgebildet sein, die keine Ein- oder Austrittsstelle für ein Fluid darstellen. Die Erhöhungen können zur Leitung des Fluid dienen. Dabei kann die Erhöhung von dem Rand des entsprechenden Hüllkörperteils beabstandet verlaufen und zumindest an einem Ende eine Biegung zu dem Rand aufweisen. Dies ermöglicht eine Beeinflussung eines Druckgefälles innerhalb eines strömenden Fluids.

Gemäß einer Ausführungsform kann zumindest eines der Hüllkörperteile profiliert sein. Dadurch kann ein erhöhter Wärmeübergang zwischen dem entsprechenden Hüllkörperteil und einem, entlang dem Hüllkörperteil strömenden Fluid erzielt werden. Die Profilierung kann eine Mehrzahl von Rippen umfassen, die sich aus dem entsprechenden Hüllkörperteil erheben.

Ferner kann der Hüllkörper eine Metallisierung zur elektrischen Kontaktierung der thermoelektrischen Elemente aufweisen. Die Metallisierung kann auf einer Innenseite ausgeführt sein, um die thermoelektrischen Elemente untereinander zu verbinden. Auf diese Weise sind keinen zusätzlichen Leiter zur Verbindung der thermoelektrischen Elemente untereinander erforderlich. Dazu kann die Metallisierung eine entsprechende Strukturierung aufweisen. Ferner kann die Metallisierung auf einer Außenseite des Hüllkörpers ausgeführt sein und einen äußeren elektrischen Anschluss ermöglichen.

Auch kann zwischen zwei benachbarten thermoelektrischen Elementen ein thermisch und elektrisch isolierendes Material angeordnet sein. Das Material kann eine vordefinierte, gasförmige, flüssige oder feste Substanz sein.

Die thermoelektrische Vorrichtung kann eine Halterung zum Bereitstellen einer Einbauschnittstelle zu einem Wärmetauscher umfassen, wobei die Halterung eine Verbindung zu dem ersten Hüllkörperteil und/ oder eine Verbindung zu dem zweiten Hüllkörperteil des Hüllkörpers aufweist. Die Halterung kann, wie in der Druckschrift mit dem amtlichen Aktenzeichen 10 2009 016 363.8 beschrieben, ausgeführt sein. Bevorzugt ist hierbei die Halterung mit dem ersten Hüllkörperteil verbunden.

Die vorliegende Erfindung schafft ferner einen Wärmetauscher, mit folgenden Merkmalen: mindestens einer thermoelektrische Vorrichtung gemäß einem der vorangegangenen Ansprüche; und eine Halterung, die ausgebildet ist, um die mindestens eine thermoelektrische Vorrichtung aufzunehmen. Ein solcher Wärmetauscher kann beispielsweise in einem Fahrzeug eingesetzt werden, um zumindest einen Teil der Wärmeenergie des Abgases in elektrische Energie umzuwandeln, die dem Fahrzeug zur Verfügung gestellt werden kann.

Dabei kann der Wärmetauscher eine erste thermoelektrische Vorrichtung und eine zweite thermoelektrische Vorrichtung aufweisen, die einander gegenüberliegend angeordnet sind. Die Halterung kann ausgebildet sein, um sowohl die erste als auch die zweite thermoelektrische Vorrichtung in einem Randbereich zu umschließen. Durch den Einsatz zweier thermoelektrischer Vorrichtungen können Wärmeverluste reduziert werden.

Dabei kann zumindest eine der ersten und zweiten thermoelektrischen Vorrichtungen mindestens einen Abstandshalter aufweisen, der ausgebildet ist, um einen inneren Zwischenraum zwischen der ersten und der zweiten thermoelektrischen Vorrichtung zu schaffen. Durch den Zwischenraum kann ein Fluid strömen.

Ferner kann der mindestens eine Abstandshalter ausgebildet sein, um einen äußeren Zwischenraum zwischen der ersten und der zweiten thermoelektrischen Vorrichtung sowie der Halterung zu schaffen. Dadurch kann ein seitlicher Wärmeaustausch reduziert werden.

Die vorliegende Erfindung schafft ferner ein Verfahren zum Herstellen einer thermoelektrischen Vorrichtung, das die folgenden Schritte aufweist: Bereitstellen eines ersten Hüllkörperteils und eines zweiten Hüllkörperteils, die jeweils als Keramikgrundkörper ausgebildet sind, der zumindest in einem Randbereich eine Metallisierung aufweist; Anordnen einer Mehrzahl thermoelektrischer Elemente, zwischen dem ersten und dem zweiten Hüllkörperteil, Erstellen einer Kontaktierung, um die Mehrzahl thermoelektrischer Elemente zu verbinden; und Erstellen einer fluiddichten Verbindung zwischen dem ersten und dem zweiten Hüllkörperteil. Die Kontaktierung kann mittels eines Lötprozess erfolgen. Die fluiddichte Verbindung kann über einen Löt-, Klebe- oder Schweißprozess erfolgen.

Bevorzugte Ausführungsbeispiele der vorliegenden Erfindung werden nachfolgend Bezug nehmend auf die beiliegenden Zeichnungen näher erläutert. Es zeigen:
- Fig. 1: eine allgemeine Skizze einer beispielhaften TEM-Ausführung im Quer- schnitt;
- Fig. 2: eine allgemeine Skizze einer beispielhaften TEM₋Ausführung isomet- risch im Schnitt;
- Fig. 3: einen Ausschnitt eines Basis-TEM im Querschnitt;
- Fig. 4: einen Ausschnitt eines Basis-TEM isometrisch;
- Fig. 5: einen TEM im Querschnitt;
- Fig. 6: ein Hüllkörper-Teil isometrisch;
- Fig. 7: einen Ausschnitt des seitlichen Bereiches des TEM im Querschnitt;
- Fig. 7a: einen Ausschnitt des seitlichen Bereiches des TEM im Querschnitt;
- Fig. 7b: einen Ausschnitt des seitlichen Bereiches des TEM im Querschnitt;
- Fig. 7c: einen Ausschnitt des seitlichen Bereiches des TEM im Querschnitt;
- Fig. 8: eine Halterung mit TEM isometrisch;
- Fig. 9: einen Ausschnitt des TEM mit Halterung im seitlichen Bereich im Quer- schnitt;
- Fig. 10: einen TEM mit Erhöhung und Anlaufschräge isometrisch;
- Fig. 11: einen Ausschnitt des TEM mit Erhöhung und Anlaufschräge im seitli- chen Bereich der strömungsbezogenen Ein- und Austrittsstellen isomet- risch;
- Fig. 12: einen Ausschnitt des TEM im Bereich der strömungsbezogenen Ein- und Austrittsstellen im Querschnitt;
- Fig. 13: einen TEM mit Berippung als Draufsicht;
- Fig. 14: einen Ausschnitt eines TEM mit Metallisierungen und Leitermaterialien im Querschnitt; und
- Fig. 15: einen Ausschnitt eines TEM mit Metallisierungen im Querschnitt.

In der nachfolgenden Beschreibung der bevorzugten Ausführungsbeispiele der vorliegenden Erfindung werden für die in den verschiedenen Zeichnungen dargestellten und ähnlich wirkenden Elemente gleiche oder ähnliche Bezugszeichen verwendet, wobei eine wiederholte Beschreibung dieser Elemente weggelassen wird.

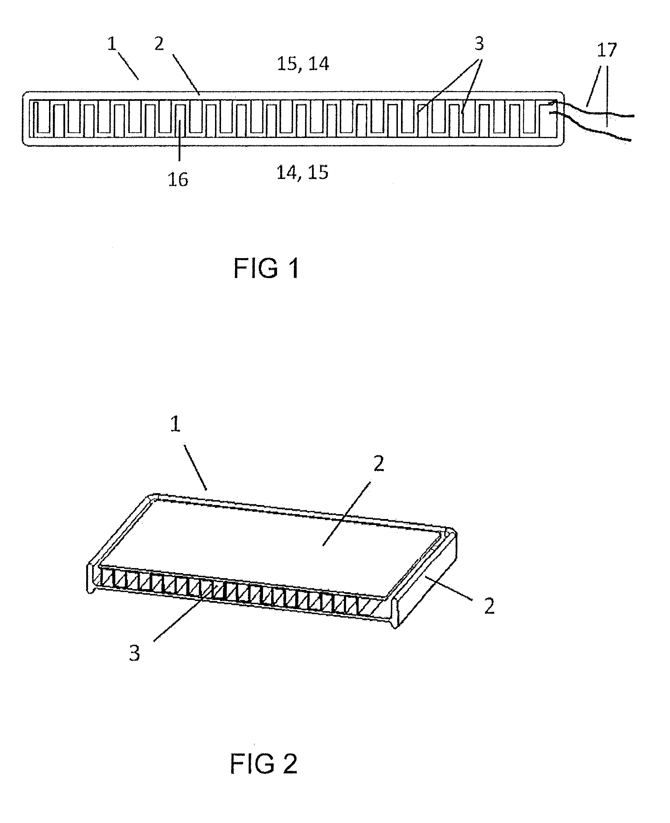

Die Figuren 1 bis 15 zeigen thermoelektrische Vorrichtungen, gemäß unterschiedlichen Ausführungsbeispielen der vorliegenden Erfindung. Dabei können die thermoelektrischen Vorrichtungen ein thermoelektrisches Modul (TEM) 1, ein Hüllkörper 3 des TEM 1, thermoelektrisch (TE) aktive Materialien 3, ein Inneres 4 des TEM 1, eine Berippung 5 des Hüllkörpers, eine Fügestelle 6 der Hüllkörper-Teile, ein Rand 7 des Hüllkörpers, eine Metallisierung, ggf. auch Klebung 8, ein Leitermaterial 9, ein Äußeres bzw. eine Außenseite 8 des TEM 1, eine Halterung 11, ein Wärmetauscher (TEG) 12 (nicht gezeigt in den Figuren), ein strömungstechnischer Ein- und Austrittsbereich 13 des TEM 1, eine innenseitige Strömung 14 eines Medium 1, eine außenseitige Strömung 15 eines Medium 2, ein Zwischenraum 16 zwischen TE-aktive Materialien 3, ein elektrisches Anschlusskabel 17, eine Erhöhung 18 im Randbereich des Hüllkörpers 2, einen Spalt 19 zwischen Erhöhung des TEM 1 und der Halterung 11, eine Barriereschicht 20, ein Elektro-Kabei 21 (nicht gezeigt in den Figuren) im TEM 1, eine Anlaufschräge 22 im Verlauf der Erhöhung und ein schräggestellter Rand 23 des Hüllkörpers 2 gezeigt.

Das erfindungsgemäße thermoelektrische Modul 1 wird in bevorzugter Weise von einem zweiteiligen, keramischen Hüllkörper 2a, 2b umschlossen, der die inneren 4 TE-aktiven Materialien 3, z.B. dotierte Halbleiter, beinhaltet.

Dabei ist der Hüllkörper 2 fluiddicht, thermisch gut leitend und elektrisch isolierend. Ferner kann der Hüllkörper 2 teilweise berippt 5 sein.

Die beiden Hüllkörper-Teile 2a, 2b sind in ihrem Aussehen von dünnwandiger und blechartig flächiger oder schachtelartiger Gestalt. Die Fügestelle 6 der beiden Hüllkorper-Teile 2a, 2b befindet sich im seitlichen Bereich des TEM 1, und somit am erfindungsgemäßen Rand 7 des Hüllkörpers 2. Erfindungsgemäß werden die beiden Hüllkörper-Teile 2a, 2b miteinander verlötet, wobei dann die keramischen Hüllkörper-Teile 2a, 2b an der Fügestelle 6 metallisiert 8 sind. Die Metallisierung 8 wird vor dem Sintern der Keramik auf den Grünling aufgebracht. Für die Lötung der beiden Hüllkörper-Teile 2a, 2b kann dann zusätzlich ein Lot erforderlich sein. Erfindungsgemäß können die beiden Hüllkörper-Teile 2a, 2b auch miteinander verklebt oder durch Ultraschallschweißen verbunden sein.

Im Inneren 4 des TEM 1 befinden sich eine Vielzahl klötzchenartiger TE-aktiver Materialien 3, die miteinander über Leitermaterialien 9, z.B. Kupfer, elektrisch parallel oder seriell verschaltet sind. Die TE-aktiven Materialien 3 und die Leitermaterialien 9 können miteinander verlötet sein. Für die Lötung kann dann zusätzlich ein Lot erforderlich sein.

Erfindungsgemäß werden der Hüllkörper 2 und die Leitermaterialien 9 in vorteilhafter Weise miteinander verlötet, wobei dann der keramische Hüllkörper 2 an den Fügestellen metallisiert 8 ist. Die Metallisierung 8 wird vor dem Sintern der Keramik auf den Grünling in Form einer dünnen Schicht aufgebracht. Für die Verlötung des Hüllkörpers 2 mit den Leitermaterialien 9 kann dann zusätzlich ein Lot erforderlich sein.

Erfindungsgemäß kann die elektrische Verschaltung der TE-aktiven Materialen 3 über die Metallisierung 8 des keramischen Hüllkörpers 2 erfolgen, wobei dann ein zusätzliches Leitermaterial 9 überflüssig wird. In diesem erfindungsgemäßen Fall werden der Hüllkörper 2 und die TE-aktiven Materialien 3 in vorteilhafter Weise miteinander verlötet, wobei dann der keramische Hüllkörper 2 an den entsprechenden Fügestellen metallisiert 8 ist. Die Metallisierung 8 wird vor dem Sintern der Keramik auf den Grünling aufgebracht. Für die Verlötung des Hüllkörpers 2 mit den TE-aktiven Materialien 3 kann dann zusätzlich ein Lot erforderlich sein.

Die Metallisierung 8 der Hüllkörper-Keramik 2 kann auch als Stromdurchführung und als elektrische Anbindung des TEM 1 genutzt werden. Daher kann die Metallisierung 8 sowohl auf der Innen 4 als auch auf der Außenseite 10 des Hüllkörpers 2 aufgebracht werden und/oder miteinander verbunden sein, sodass elektrischer Strom aus dem TEM 1 über die Metallisierungen 8 herausgeführt werden kann.

Das TEM 1 kann über eine Halterung 11 in einem Wärmetauscher (TEG) 12 verbaut sein. Die Halterung 11 kann neben einem metallischen Werkstoff, z.B. Edelstahl, erfindungsgemäß auch aus einem keramischen Werkstoff sein.

Erfindungsgemäß werden TEM 1 und Halterung 11 miteinander verlötet, wobei dann die keramischen Teile an der Fügestelle metallisiert 8 sind. Für die Lötung kann dann zusätzlich ein Lot erforderlich sein. Erfindungsgemäß können TEM 1 und Halterung 11 auch durch Ultraschallschweißen oder Klemmverbindungen verbunden sein. Erfindungsgemäß kann die Verbindung zwischen Hüllkörper 2 und Halterung 11 im peripheren seitlichen Bereich des Hüllköpers 2 z.B. bei Klebung als auch im mittleren, flächigen Bereich des Hüllkörpers 2 bestehen. Auch ist eine Verklebung des TEM 1 mit der Halterung 11 möglich.

Erfindungsgemäß können mehrere Anforderungen an das TEM 1gelöst werden. So kann der Hüllkörper 2 des TEM 1fluiddicht gestaltet werden. Dazu kann die Fügestelle 6 des zweiteiligen Hüllkörpers 2a, 2b des TEM 1 ist so konzipiert werden, dass die Fluiddichtheit im Betrieb gewahrt bleibt. Ferner kann das TEM 1 über eine Halterung 11 in einem TEG 12 implementiert werden. Dabei kann der Hüllkörper 2 des TEM 1 so gestaltet werden, dass möglichst geringe Wärmeverluste über die Halterung 11 auftreten. Ferner kann der Hüllkörper 2 des TEM 1 so gestaltet werden, dass es zu geringen Druckabfällen im strömungstechnischen Ein- und Austrittsbereich des TEM 13 kommt. Auch kann der Hüllkörper 2 des TEM 1 so gestaltet sein, dass die anliegenden Temperaturdifferenzen 14-15 am TEM 1 möglichst hoch ausfallen. Dies kann durch eine Berippung 5 herbeigeführt, die die Wärmeübergänge auf der Außenseite 10 des TEM 1 erhöhen. Die TE-Materialien 3 und/oder Leitermaterialien 9 können mit dem TEM-Hüllkörper 2 stoffschlüssig und temperaturbeständig verbunden sein. Ferner kann sich zwischen den TE-Materialien 3 ein elektrisch und thermisch isolierender Bereich 16 befinden. Zudem können elektrische Anbindung 17 des TEM 1 vorgesehen sein.

Das erfindungsgemäße TEM 1 kann im Wesentlichen und standardmäßig aus TE-aktiven Halbleitermaterialien 3, elektrischen Leitern 9 und Anschlusskabel 17 bestehen. Das TEM 1 kann optional noch zusätzlich aus einem Hüllkörper 2 und Füllkörper im Zwischenraum 16 bestehen.

Allgemein kann am TEM 1 außerhalb 15 auf einer Seite 14, 15 eine Wärmequelle und auf der anderen Seite 15, 14 eine Wärmesenke anliegen, sodass es auf Grund der unterschiedlichen Temperaturen 14-15 zu einem Wärmetransport von der warmen 14, 15 zur kalten Seite 15,14 kommt.

Nachfolgend sind verschiedene konstruktive Ausführungen aufgelistet, wobei diese miteinander beliebig kombinierbar sind, sodass es ferner noch zu weiteren Kombi-Ausführungen kommen kann.

Fig. 1 zeigt eine Darstellung einer thermoelektrischen Vorrichtung, gemäß einem Ausführungsbeispiel der vorliegenden Erfindung. Insbesondere ist eine allgemeine Skizze einer beispielhaften TEM-Ausführung im Querschnitt gezeigt. Anhand von Fig. 1 wird auch eine Erzeugung elektrischer Energie mit dem TEM 1 beschrieben.

Die Trennebene oder Trennfläche zwischen heißer Seite 14, 15 und kalter Seite 15, 14 stellt das thermoelektrische Modul 1 (TEM) dar. Das bedeutet, dass eine Seite 14, 15 des TEM 1 in direktem oder indirektem Kontakt zu einer heißen Quelle 14, 15 steht, und die andere 15, 14 in direktem oder indirektem Kontakt zu einem kalten 15, 14 Bereich. Die hierdurch anstehende Temperaturdifferenz 14-15 zwischen der einen und anderen Seite 14-15 des TEM 1 ruft Thermodiffusionsströme innerhalb der thermoelektrisch aktiven Materialien 3, z.B. Halbleiter-Materialien, in dem TEM 1 hervor, wodurch eine elektrische Spannung entsteht Dies kann gemäß dem Seebeck-Effekt erfolgen. Die elektrische Spannung kann in Form von elektrischem Strom abgegriffen werden. Hierzu wird der elektrische Strom über Elektro-Kabel 17, die an das TEM 1 führen und dort angeschlossen sind, einem elektrischen Verbraucher oder einem elektrischen Speicher außerhalb des TEM 1 zugeführt.

Fig. 2 zeigt eine weitere Darstellung der in Fig. 1 gezeigten thermoelektrischen Vorrichtung. Insbesondere ist eine allgemeine Skizze einer beispielhaften TEM-Ausführung isometrisch im Schnitt gezeigt.

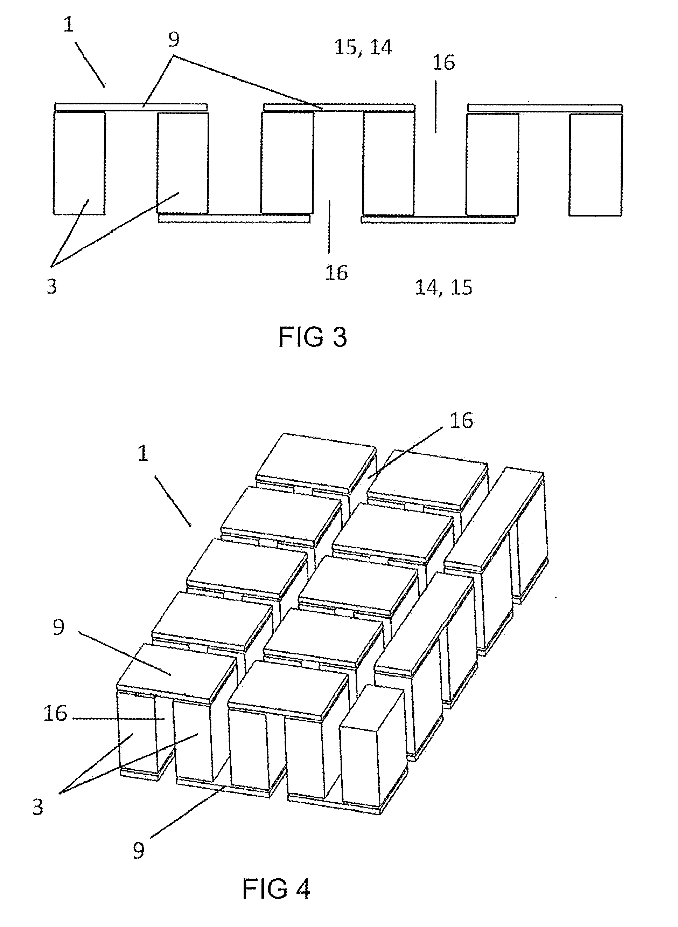

Fig. 3 zeigt eine Darstellung einer thermoelektrischen Vorrichtung, gemäß einem weiteren Ausführungsbeispiel der vorliegenden Erfindung. Insbesondere ist einen Ausschnitt eines Basis-TEM 1 im Querschnitt gezeigt. Anhand von Fig. 3 wird der Aufbau des TEM 1 beschrieben.

In dem TEM 1 wird abwechselnd eine Vielzahl thermoelektrisch aktiver Materialien 3, z.B. n- und p-dotierte Halbleiter, über elektrische Leiter 9 miteinander verschaltet. Die geometrische Ausrichtung der thermoelektrisch aktiven Materialien 3 weist in Richtung dem Wärmestrom von der Warmseite 14, 15 zur Kaltseite 15, 14. Als Werkstoff der TE-aktiven Materialien 3 kommt beispielsweise PbTe oder BiTe in Frage.

Die TE-aktiven Materialen 3 berühren sich gegenseitig nicht, weshalb ein Zwischenraum 16 zwischen den TE-aktiven Materialien 3 besteht. Grundsätzlich sollte aus Effizienzgründen das Verhältnis Volumen TE-aktive Materialien 3 zu Volumen Zwischenraum 16 möglichst groß sein.

Um die gewünschten elektrischen Spannungen und Stromflüsse einzustellen, können die TEM 1 -internen Halbleiter-Leitermaterialen gleich- oder parallelverschaltet werden. Dies gilt auch für die elektrische Verschaltung mehrerer TEM 1 untereinander.

Fig. 4 zeigt eine weitere Darstellung der in Fig. 3 gezeigten, thermoelektrischen Vorrichtung. Insbesondere ist einen Ausschnitt eines Basis-TEM 1 isometrisch gezeigt. Ein thermoelektrisches Elemente 3 kann zu einem ersten benachbarten thermoelektrischen Element 3 über eine erste Kontaktfläche und zu einem zweiten benachbarten thermoelektrischen Element 3 über eine zweite, der ersten Kontaktfläche gegenüberliegenden Kontaktfläche elektrisch leitend verbunden sein. Auf diese Weise können benachbarte thermoelektrische Elemente 3 in Serie oder auch parallel geschaltet sein. Die Leiter 9 können die Kontaktflächen vollständig abdecken.

Die thermoelektrische Elemente 3 können quaderförmig sein. Die thermoelektrischen Elemente 3 können in einer Mehrzahl von Reihen und Spalten, also matrixförmig angeordnet sein. Sowohl in Bezug auf die Reihen als auch in Bezug auf die Spalten können die thermoelektrischen Elemente 3 jeweils parallel zueinander ausgerichtet sein. In einer Reihe angeordnete thermoelektrische Elemente 3 können jeweils in Serie geschaltet sein. Ebenso können die einzelnen Reihen miteinander in Serie geschaltet sein.

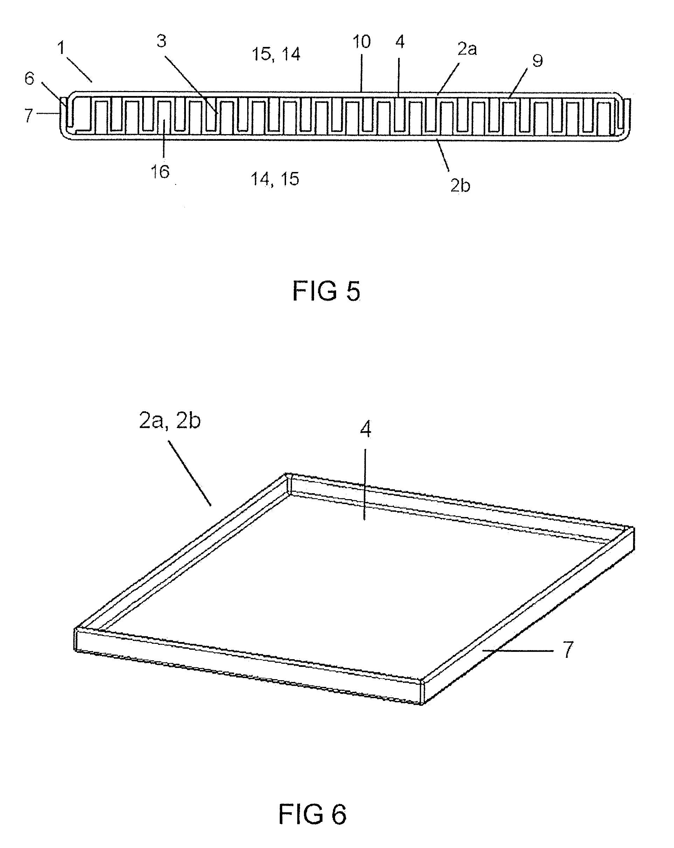

Anhand der Figuren 5 und 6 wird eine fluiddichte Ausgestaltung des Hüllkörpers 2 des TEM 1 beschrieben.

Fig. 5 zeigt eine Darstellung einer thermoelektrischen Vorrichtung, gemäß einem weiteren Ausführungsbeispiel der vorliegenden Erfindung. Insbesondere ist ein TEM 1 im Querschnitt gezeigt.

Die TE-aktiven Materialien 3 werden von einer elektrisch isolierenden und thermisch gut leitenden Hüllschicht 2, einem sogenannten Hüllkörper 2 umgeben. Dieser Hüllkörper 2 kann aus einem ein- oder mehrteiligen metallischen oder keramischen Werkstoff bestehen. Der Hüllkörper 2 umschließt die TE-aktiven Materialien 3 erfindungsgemäß vollständig und fluiddicht, sodass kein Stoffaustausch von außen 10 nach innen 4 oder umgekehrt erfolgen kann. Dies gilt auch für die elektrischen Stromdurchführung des TEM 1 und dessen Anbindung sowie die Fügestellen 6 der Hüllkörper-Teile 2a, 2b.

In der erfindungsgemäßen, bevorzugten Ausführung besteht der Hüllkörper 2 aus einem zweiteiligen, keramischen Werkstoff, z.B. Aluminium-Oxid, Zirkonium-Oxid, Aluminim-Nitrat, Aluminium-Titanat, Aluminium-Silikat oder Bornitrat, bzw. Mischformen hieraus 2a, 2b. Der thermische Ausdehnungskoeffizient ist in bevorzugter Weise an die Halterung 11 des TEM 1 angepasst, sodass es bei wechselnden Temperaturen im Betrieb zu keiner Beschädigung der Verbindungsstelle TEM 1 -Halterung 11 kommt.

Die beiden Hüllkörper-Teile 2a, 2b sind äußerlich von dünnwandiger und blechartig flächiger oder schachtelartiger Gestalt und werden im Bereich des Randes 7 miteinander gefügt 6.

Fig. 6 zeigt eine isometrische Darstellung eines Hüllkörper-Teil 2a, 2b, gemäß einem Ausführungsbeispiel der vorliegenden Erfindung. Das Hüllkörper-Teil 2a, 2b kann für das in Fig. 5 gezeigte TEM 1 eingesetzt werden.

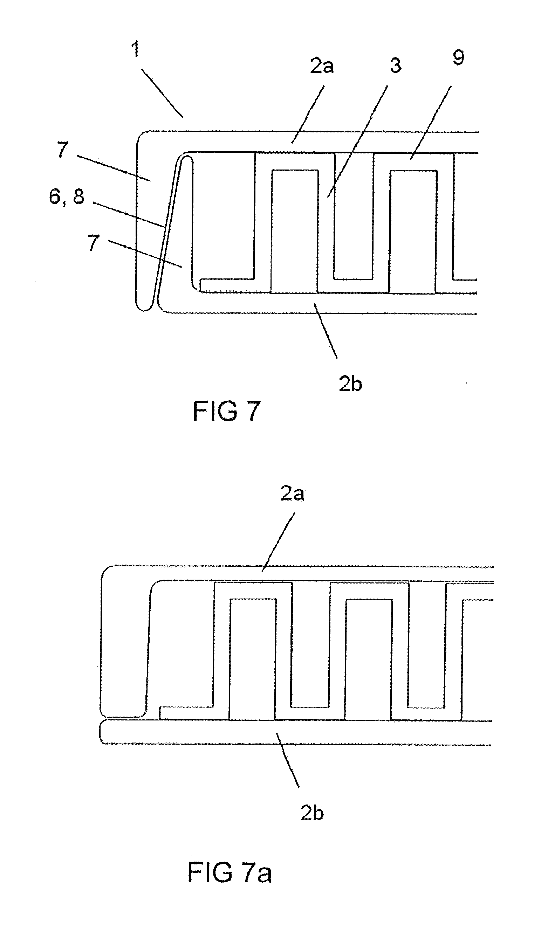

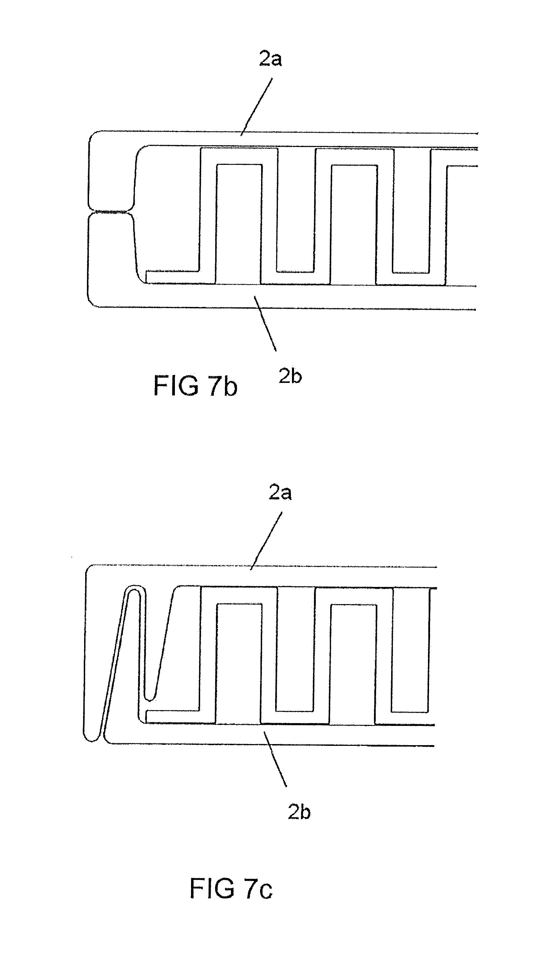

Anhand der Figuren 7 bis 7c die Fügestelle 6, des zweiteiligen Hüllkörpers 2a, 2b des TEM 1 beschrieben. Dabei zeigen die Figuren 7, 7a, 7b, 7c einen Ausschnitt des seitlichen Bereiches des TEM im Querschnitt, gemäß unterschiedlichen Ausführungsbeispielen der vorliegenden Erfindung.

Die Fügestelle 6 der beiden Hüllkörper-Teile 2a, 2b befindet sich im seitlichen Bereich. Erfindungsgemäß werden die beiden Hüllkörper-Teile 2a, 2b miteinander verlötet, wobei dann die keramischen Hüllkörper-Teile 2a, 2b an der Fügestelle metallisiert 8 sind. Die Metallisierung 8 wird vor dem Sintern der Keramik auf den Grünling aufgebracht. Für die Lötung der beiden Hüllkörper-Teile 2a, 2b kann dann zusätzlich ein Lot erforderlich sein. Erfindungsgemäß können die beiden Hüllkörper-Teile 2a, 2b auch miteinander verklebt oder durch Ultraschallschweißen verbunden sein. Nachfolgend sind einige gestalterische Ausführungen der Verbindungsstelle der Hüllkörper-Teile 2a, 2b dargestellt.

Gemäß dem in Fig. 7 gezeigten Ausführungsbeispiel weisen die Hüllkörper-Teile 2a, 2b jeweils an den Rändern zueinander zeigende Nasen auf. Die Nase des Hüllkörper-Teils 2a weist dabei auf der Innenseite eine Abschrägung auf, so dass sich die Nase zum Ende hin verjüngt. Die Nase des Hüllkörper-Teils 2b weist auf der Außenseite eine korrespondierende Abschrägung auf, so dass sich die Nase zum Ende hin ebenfalls verjüngt. Aufgrund der Abschrägungen kann eine durch die beiden Nasen gebildete Seitenwand eine gleichmäßige Dicke aufweisen.

Gemäß dem in Fig. 7a gezeigten Ausführungsbeispiel weist das Hüllkörper-Teil 2a an den Rändern eine rechtwinklige Biegung auf, die auf einer Oberfläche des planen Hüllkörper-Teils 2b aufliegt.

Gemäß dem in Fig. 7b gezeigten Ausführungsbeispiel weisen die Hüllkörper-Teile 2a, 2b jeweils an den Rändern eine rechtwinklige Biegung auf, deren Enden aneinanderstoßen.

Gemäß dem in Fig. 7c gezeigten Ausführungsbeispiel weisen die Hüllkörper-Teile 2a, 2b jeweils an den Rändern zueinander zeigende Nasen auf, die den anhand von Fig. 7 beschriebenen Nasen entsprechen. Das Hüllkörper-Teil 2a weist dabei eine zusätzliche, weiter innen liegende Nase auf. Die Nase des Hüllkörper-Teils 2b kann zwischen die beiden nebeneinanderliegenden Nasen des Hüllkörper-Teils 2a formschlüssig eingefügt werden.

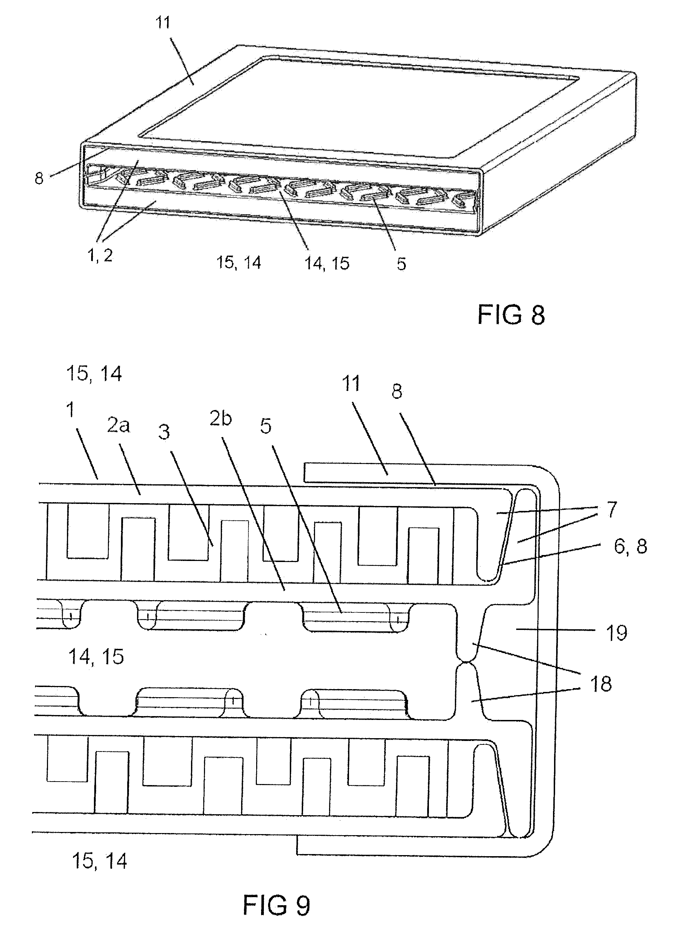

Fig. 8 zeigt eine Darstellung einer thermoelektrischen Vorrichtung, gemäß einem weiteren Ausführungsbeispiel der vorliegenden Erfindung. Insbesondere ist eine Halterung 11 mit TEM 1 isometrisch gezeigt. Das TEM 1 kann über die Halterung 11 in einem TEG 12 implementiert werden.

Das TEM 1 wird über die Halterung 11 in einem Wärmetauscher (TEG) 12 verbaut. Die Halterung 11 kann neben einem metallischen Werkstoff, z. B. Edelstahl, erfindungsgemäß auch aus einem keramischen Werkstoff sein. Der Halter 11 fasst und positioniert ein oder mehrere TEM 1.

Erfindungsgemäß werden TEM 1 und Halterung 11 miteinander verlötet, wobei dann die keramischen Teile an der Fügestelle metallisiert 8 sind. Für die Lötung kann dann zusätzlich ein Lot erforderlich sein. Erfindungsgemäß können TEM 1 und Halterung 11 auch durch Ultraschallschweißen oder Klemmverbindung verbunden sein. Auch kann eine Verklebung des TEM 1 mit der Halterung 11 erfolgen.

Die Halterung 11 kann erfindungsgemäß mit dem Wärmetauscher (TEG) 12 lasergeschweißt, ultraschallgeschweißt, geklebt oder gelötet sein, wobei eine Verbindung auf keramisch-metallischer Basis auch hier auf einer Metallisierung 8 der Keramik beruht.

Die Halterung 11 kann eine Aussparung aufweisen, die einen Großteil einer Oberfläche des Hüllkörpers 2 frei lässt.

Anhand von Fig. 9 wird eine vorteilhafte Ausgestaltung des Hüllkörpers 2 bezüglich Wärmeverluste beschrieben.

Fig. 9 zeigt eine Darstellung einer thermoelektrischen Vorrichtung oder einen Wärmetauscher, der zwei einzelne thermoelektrischen Vorrichtungen umfasst, gemäß einem weiteren Ausführungsbeispiel der vorliegenden Erfindung. Insbesondere ist einen Ausschnitt des TEM 1 mit Halterung 11 im seitlichen Bereich im Querschnitt gezeigt.

Das TEM 1 kann im seitlichen Randbereich ein oder beidseitig erhöht 18 sein, um die wirksamen Verbindungsflächen mit der Halterung 11 zu vergrößern.

In bevorzugter Weise fasst die Halterung 11 zwei gegenüberliegende TEM 1, sodass zwischen den beiden TEM 1, also innerhalb der Halterung 11 ein Medium 14 strömen kann. Außerhalb der Halterung 11 strömt dann das andere Medium 15. Um Wärmeverluste zu beschränken kann dann das TEM 1 im seitlichen Randbereich mit einer Erhöhung 18 ausgeführt werden. Diese Erhöhung 18 ist so gestaltet, dass sich das obere TEM 1 in der Halterung 11 und das untere TEM 1 in der Halterung 11 näherungsweise im Bereich der jeweiligen Erhöhungen 18 berühren. Da die Erhöhung 18 einen gewissen Abstand zur Halterung 11 aufweist, bildet sich ein Spalt 19 zwischen Halterung 11 und TEM 1 im Bereich der Erhöhungen 18. Im Spalt 19 ist die innenseitige Strömung 14 weniger ausgeprägt. Durch diese Maßnahme einer thermischen Trennung in Form eines Spalts 19 kann im seitlichen Bereich der Halterung 11 der unerwünschte Wärmeaustausch zwischen Innenseite 14 und Außenseite 15 reduziert werden.

Die innenseitig gelegenen Hüllkörperoberflächen können Rippen 5 aufweisen Die Halterung 11 kann einen Randbereich des oberen TEM 1, einen Randbereich des unteren TEM 1 sowie einen dazwischenliegenden Seitenbereich umschließen. Dabei kann die Halterung 11 jeweils an den entsprechenden Oberflächen der TEM 1 anliegen und mit diesen verbunden sein.

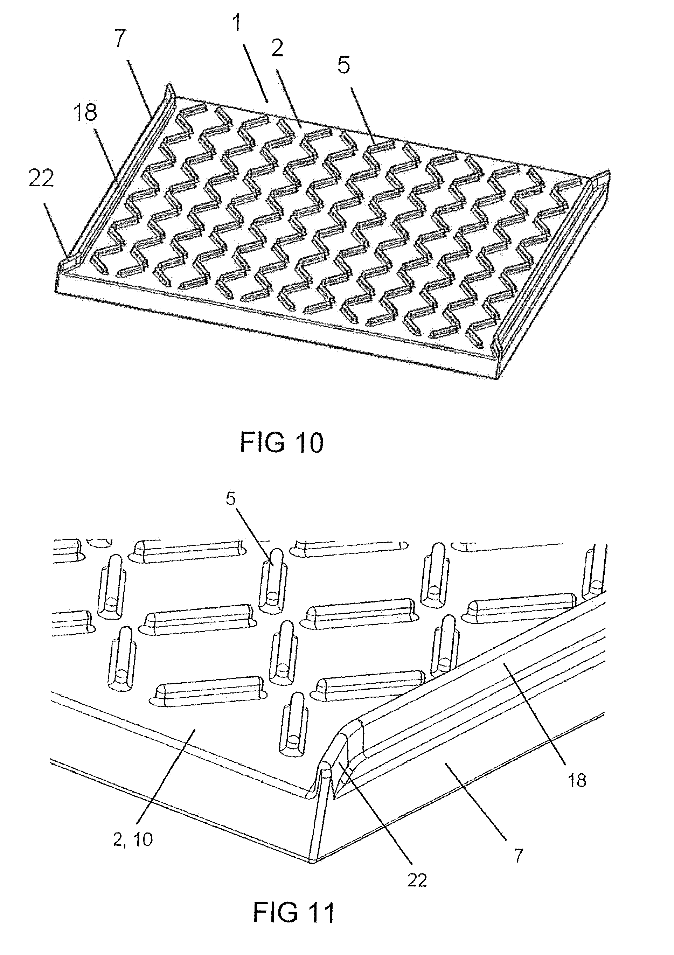

Anhand der Figuren 10 bis 12 werden geringere Druckabfälle im strömungstechnischen Ein- und Austrittsbereich 13 des TEM 1 beschrieben.

Fig. 10 zeigt eine Darstellung einer thermoelektrischen Vorrichtung, gemäß einem weiteren Ausführungsbeispiel der vorliegenden Erfindung. Insbesondere ist einen TEM 1 mit Erhöhung 18 und Anlaufschräge 22 isometrisch gezeigt.

Die Erhöhung 18 im seitlichen Bereich des TEM 1 kann in vorteilhafter Weise in Form einer Anlaufschräge 22 an den strömungsbezogenen Ein- und Austrittsstellen 13 des TEM 1 in Richtung Halterung 11 geführt werden. An den Ein- und Austrittstellen 13 ist dann kein nennenswerter Spalt 19 ausgebildet. Somit rückt die Erhöhung 18 erst im strömungstechnisch mittleren Bereich des TEM 1 nach innen, sodass sich ein Spalt 19 ausbildet, während die Erhöhung 18 an den strömungsbezogenen Ein- und Austrittsstellen 13 des TEM 1 an den Rand 7 geführt wird. Hierdurch sinken die innenseitigen 14 Druckabfälle im Ein- und Austritt 13. Außerdem wird die Ausprägung der Strömung innerhalb des Spaltes 19 in vorteilhafter Weise durch die Anlaufschräge 22 weiter reduziert, sodass die Massenstromdichte hier abnimmt.

Der Hüllkörper 2 kann eine Mehrzahl von Rippen 5 aufweisen, die rautenförmig angeordnet sein können. Die Erhöhung 18 kann an gegenüberliegenden Seiten des TEM 1 ausgebildet sein, die nicht als Eintrittsseiten oder Austrittsseiten für das Fluid dienen.

Fig. 11 zeigt einen isometrisch dargestellten Ausschnitt des in Fig. 10 gezeigten TEM 1 mit der Erhöhung 18 und der Anlaufschräge 22 im seitlichen Bereich der strömungsbezogenen Ein- und Austrittsstellen 13.

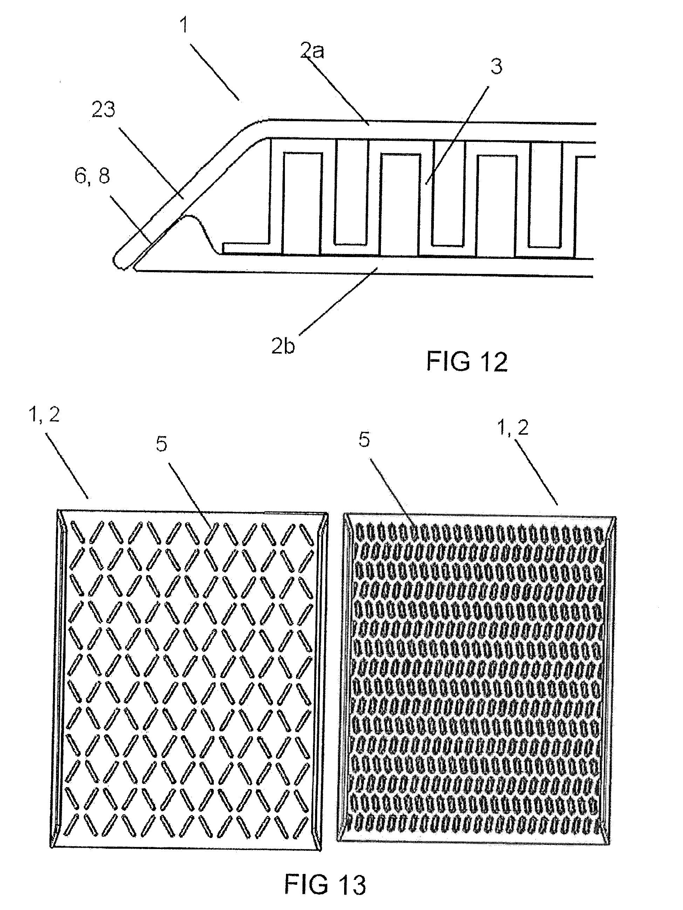

Fig. 12 zeigt eine Darstellung einer thermoelektrischen Vorrichtung, gemäß einem weiteren Ausführungsbeispiel der vorliegenden Erfindung. Insbesondere ist einen Ausschnitt des TEM 1 im Bereich der strömungsbezogenen Ein- und Austrittsstellen 13 im Querschnitt gezeigt.

Alternativ oder ergänzend zu der in den Figuren 10 und 11 gezeigten Erhöhung 18 kann der Rand 7 des TEM 1 an der strömungsbezogenen Ein- und Austrittsstellen erfindungsgemäß schräg gestellt werden 23, um die Druckabfälle zu reduzieren.

Gemäß diesem Ausführungsbeispiel ist ein Randbereich des Hüllkörper-Teils 2a schräg nach unten gebogen. Das Hüllkörper-Teil 2b kann im Randbereich eine dem Hüllkörper-Teil 2a zugewandte abgeschrägte Erhebung aufweisen, an das das gebogene Endstück des Hüllkörper-Teils 2b anschließen kann. Anhand von Fig. 13 wird gezeigt, dass der Hüllkörper 2 des TEM 1 gerippt sein kann.

Fig. 13 zeigt eine Darstellung zweier thermoelektrischer Vorrichtungen, gemäß weiteren Ausführungsbeispielen der vorliegenden Erfindung. Insbesondere sind zwei nebeneinander angeordnete TEM 1 mit Berippung 5 als Draufsicht gezeigt.

Der Hüllkörper 2 der TEM 1 ist so gestaltet, dass die anliegenden Temperaturdifferenzen 14-15 an den TEM 1 möglichst hoch ausfallen. Dies wird durch eine Berippung 5 realisiert, die die Wärmeübergänge am Hüllkörper 2 zur Innen 14, 10- und/oder Außenseite 15, 10 der TEM 1 erhöht und zudem die Wärmeübertragungsfläche vergrößert. Die Rippen 5 können wie beispielhaft gezeigt, ausgeführt werden.

Gemäß dem links gezeigten Ausführungsbeispiel bedecken die Rippen 5 einen geringeren Teil der Gesamtoberfläche des Hüllkörpers 2. Gemäß dem rechts gezeigten Ausführungsbeispiel bedecken die Rippen 5 einen größeren Teil der Gesamtoberfläche des Hüllkörpers 2.

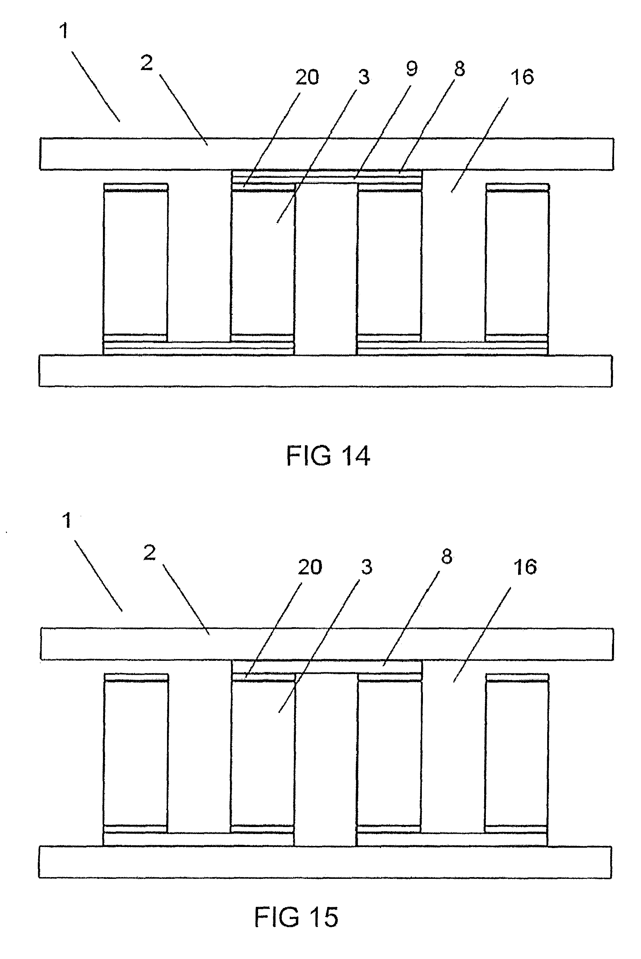

Anhand der Figuren 14 und 15 wird beschrieben, dass die TE-Materialien 3 und/oder Leitermaterialien 9 mit dem TEM-Hüllkörper 2 stoffschlüssig und temperaturbeständig verbunden sein können.

Fig. 14 zeigt eine Darstellung einer thermoelektrisehen Vorrichtung, gemäß einem weiteren Ausführungsbeispiel der vorliegenden Erfindung. Insbesondere ist ein Ausschnitt eines TEM 1 mit Metallisierungen 8 und Leitermaterialien 9 im Querschnitt gezeigt.

Die TE-aktiven Materialien 3 und die Leitermaterialien 9 können miteinander verlötet sein. Für die Lötung kann dann zusätzlich ein Lot erforderlich sein. Erfindungsgemäß werden der Hüllkörper 2 und die Leitermaterialien 9 in vorteilhafter Weise miteinander verlötet, wobei dann der keramische Hüllkörper 2 an den Fügestellen metallisiert 8 ist. Die Metallisierung 8 wird vor dem Sintern der Keramik auf den Grünling in Form einer dünnen Schicht aufgebracht. Für die Verlötung des Hüllkörpers 2 mit den Leitermaterialien 9 kann dann zusätzlich ein Lot erforderlich sein.

Erfindungsgemäß kann die elektrische Verschaltung der TE-aktiven Materialen 3 über die Metallisierung 8 des keramischen Hüllkörpers 2 erfolgen, wobei dann ein zusätzliches Leitermaterial 9 überflüssig wird. In diesem erfindungsgemäßen Fall werden der Hüllkörper 2 und die TE-aktiven Materialien 3 in vorteilhafter Weise miteinander verlötet, wobei dann der keramische Hüllkörper 2 an den entsprechenden Fügestellen metallisiert 8 ist. Die Metallisierung 8 wird vor dem Sintern der Keramik auf den Grünling aufgebracht. Für die Verlötung des Hüllkörpers 2 mit den TE-aktiven Materialien 3 kann dann zusätzlich ein Lot erforderlich sein.

Die Metallisierung 8 der Hüllkörper-Keramik 2 kann auch als Stromdurchführung und als elektrische Anbindung des TEM 1 genutzt werden, bzw. kann ein weiterer Leiter 9 für diesen Verwendungszweck an der Metallisierung 8 angelötet werden. Daher kann die Metallisierung 8 sowohl auf der Innenseite 4 als auch auf der Außenseite 10 des Hüllkörpers 2 aufgebracht werden und/oder miteinander verbunden sein, sodass elektrischer Strom aus dem TEM 1 über die Metallisierungen 8 herausgeführt werden kann.

Die TE-Materialien 3 können erfindungsgemäß mit einer Barriereschicht 20 ausgeführt werden. Die Barriereschicht 20 verhindert vor allem bei hohen Temperaturen einen Stoff-Diffusionsstrom ausgehend von den TE-Materialien 3 in die Leitermaterialien 9 oder umgekehrt, welcher die anschließende Wirksamkeit der TE-Materialien 3 in negativer Weise beeinträchtigen würde.

Fig. 15 zeigt eine Darstellung einer thermoelektrischen Vorrichtung, gemäß einem weiteren Ausführungsbeispiel der vorliegenden Erfindung. Insbesondere ist ein Ausschnitt eines TEM 1 mit Metallisierungen 8 im Querschnitt gezeigt.

Gemäß diesem Ausführungsbeispiel ist, wie bereits anhand von Fig. 14 beschrieben, kein Leiter 9 erforderlich.

Gemäß einem weiteren Ausführungsbeispiel kann sich zwischen den TE-Materialien 3 ein elektrisch und thermisch isolierender Bereich 16 befinden,

Der Zwischenraum 16 zwischen den einzelnen, klötzchenartigen TE-Materialien 3 wird möglichst thermisch und elektrisch isolierend ausgeführt. Der Zwischenraum 16 kann mit einem Gas, einer Flüssigkeit, einer amorphe Masse oder einem Festkörper ausgefüllt sein. Bei tendenziell niedrigeren Temperaturen kann der Zwischenraum 16 mit einem Kunststoff ausgegossen oder ausgeschäumt sein. Auch kann ein vorgeformter Kunststoff den TE-aktiven Materialien 3 formschlüssig übergestülpt werden. Auch kann eine Folie in die Zwischenräume 16 eingebracht werden. Bei tendenziell höheren Temperaturen kann ein keramischer, mineralischer oder glashaltiger Werkstoff vorgesehen werden. Insbesondere ein poröser keramischer, mineralischer oder glashaltiger Werkstoff kann erfindungsgemäß vorgesehen werden, wobei dann dessen Lufteinschlüsse bei über 30 Vol.-% liegt. In vorteilhafter Weise liegt dessen Lufteinschlüsse vorzugsweise bei über 50 Vol.-%.

Desweiteren sollte aus Effizienzgründen das Verhältnis Volumen TE-aktive Materialien 3 zu Volumen Zwischenraum 16 erfindungsgemäß bei größer 1, vorzugsweise bei größer 2,3 liegen.

In Fig. 1 ist eine elektrische Anbindung 17 des TEM 1 gezeigt.

Erfindungsgemäß wird das Anschlusskabel 17 ober- oder unterseitig an das TEM 1 angeschlossen. Dabei durchdringt das Anschlusskabel 17 die Ober- oder Unterseite des Hüllkörpers 2 und kontaktiert mit den TE-aktiven Materialien 3 bzw. mit den leitenden Elementen 9, 8 innerhalb 4 des TEM 1.

In einer anderen Ausführung kontaktiert das Anschlusskabel 17 mit einem anderen elektrischen Kabel 21, das vom Inneren 4 des TEM 1 nach außen 10 geführt wird, auf der Ober- oder Unterseite des TEM 1.

In einer weiteren Ausführung kontaktiert das Anschlusskabel 17 auf der Ober- oder Unterseite des Hüllkörpers 2 mit den leitenden Elementen 9, 8 außerhalb 10 des TEM 1.

Die beschriebenen Ausführungsbeispiele sind nur beispielhaft gewählt und können miteinander kombiniert werden.

## Patentansprüche

1. Thermoelektrische Vorrichtung (1), mit folgenden Merkmalen:
einem Hüllkörper (2) mit einem ersten Hüllkörperteil (2a) und einem gegenüberliegenden zweiten Hüllkörperteil (2b), die jeweils einen Randbereich (7) aufweisen und in dem Randbereich fluiddicht miteinander verbunden sind, um einen, zwischen dem ersten Hüllkörperteil und dem zweiten Hüllkörperteil angeordneten, nach außen fluiddicht abgeschlossenen Innenraum auszubilden; und
einer Mehrzahl thermoelektrischer Elemente (3), die jeweils zwei gegenüberliegende Kontaktflächen aufweisen, und wobei die thermoelektrischen Elemente so in dem Innenraum angeordnet sind, das jeweils eine erste der Kontaktflächen dem ersten Hüllkörperteil gegenüberliegend und eine zweite der Kontaktflächen dem zweiten Hüllkörperteil gegenüberliegend angeordnet ist;
**dadurch gekennzeichnet, dass**
das erste Hüllkörperteil (2a) und das zweite Hüllkörperteil (2b) jeweils als Keramikgrundkörper ausgebildet sind, der zumindest in dem Randbereich (7) eine Metallisierung aufweist.

2. Vorrichtung gemäß Anspruch 1, bei der zumindest einer der Randbereiche (7) Fügestellen (6) aufweist, die ineinandergreifen, wenn das erste und das zweite Hüllkörperteil (2a, 2b) miteinander verbunden sind.

3. Vorrichtung gemäß einem der vorangegangenen Ansprüche, bei der der Hüllkörper (2) an zumindest einem Randbereich eine Abschrägung (23) aufweist, die zwischen dem ersten und dem zweiten Hüllkörperteil (2a, 2b) verläuft.

4. Vorrichtung gemäß einem der vorangegangenen Ansprüche, bei der zumindest eines der ersten und zweiten Hüllkörperteile (2a, 2b) auf einer, dem Innenraum gegenüberliegenden Seite eine Erhöhung (18) aufweist, die entlang zumindest eines Randes des entsprechenden Hüllkörperteils verläuft.

5. Vorrichtung gemäß einem der vorangegangenen Ansprüche, bei der zumindest einer der Hüllkörperteile (2a, 2b) profiliert (5) ist.

6. Vorrichtung gemäß einem der vorangegangenen Ansprüche, bei der der Hüllkörper (2) eine Metallisierung (8) zur elektrischen Kontaktierung der thermoelektrischen Elemente (3) aufweist.

7. Vorrichtung gemäß einem der vorangegangenen Ansprüche, bei der zwischen zwei benachbarten thermoelektrischen Elementen (3) ein thermisch und elektrisch isolierendes Material (16) angeordnet ist.

8. Vorrichtung gemäß einem der vorangegangenen Ansprüche, mit einer Halterung (11) zum Bereitstellen einer Einbauschnittstelle zu einem Wärmetauscher, wobei die Halterung eine Verbindung zu dem ersten Hüllkörperteil (2a) und/ oder eine Verbindung zu dem zweiten Hüllkörperteil (2b) des Hüllkörpers (2) aufweist.

9. Wärmetauscher, mit folgenden Merkmalen:
mindestens einer thermoelektrische Vorrichtung (1) gemäß einem der vorangegangenen Ansprüche; und
eine Halterung (11), die ausgebildet ist, um die mindestens eine thermoelektrische Vorrichtung aufzunehmen.

10. Wärmetauscher gemäß Anspruch 9, mit einer ersten thermoelektrischen Vorrichtung (1) und einer zweiten thermoelektrischen Vorrichtung (1), die einander gegenüberliegend angeordnet sind, wobei die Halterung (11) ausgebildet ist, um sowohl die erste als auch die zweite thermoelektrische Vorrichtung in einem Randbereich zu umschließen.

11. Wärmetauscher gemäß Anspruch 10, bei der zumindest eine der ersten und zweiten thermoelektrischen Vorrichtungen (1) mindestens einen Abstandshalter (18) aufweist, der ausgebildet ist, um einen inneren Zwischenraum zwischen der ersten und der zweiten thermoelektrischen Vorrichtung zu schaffen.

12. Wärmetauscher gemäß Anspruch 11, bei der der mindestens eine Abstandshalter (18) ausgebildet ist, um einen äußeren Zwischenraum zwischen der ersten und der zweiten thermoelektrischen Vorrichtung (1) sowie der Halterung (11) zu schaffen.

13. Verfahren zum Herstellen einer thermoelektrischen Vorrichtung, das die folgenden Schritte aufweist:
Bereitstellen eines ersten Hüllkörperteils (2a) und eines zweiten Hüllkörperteils (2b), die jeweils als Keramikgrundkörper ausgebildet sind, der zumindest in einem Randbereich (7) eine Metallisierung aufweist;
Anordnen einer Mehrzahl thermoelektrischer Elemente (3), zwischen dem ersten und dem zweiten Hüllkörperteil;
Erstellen einer Kontaktierung, um die Mehrzahl thermoelektrischer Elemente zu verbinden; und
Erstellen einer fluiddichten Verbindung zwischen dem ersten und dem zweiten Hüllkörperteil.
